Europäisches Patentamt

European Patent Office

Office européen des brevets

(19)

(11) Numéro de publication: **0 325 526**
**A2**

## (12) DEMANDE DE BREVET EUROPEEN

(21) Numéro de dépôt: **89400131.2**

(22) Date de dépôt: **17.01.89**

(51) Int. Cl.⁴: **H 01 L 39/24**
**H 01 L 39/12**

(30) Priorité: **22.01.88 FR 8800682**

(43) Date de publication de la demande:
**26.07.89 Bulletin 89/30**

(84) Etats contractants désignés: **DE GB NL**

(71) Demandeur: **THOMSON-CSF**
**51, Esplanade du Général de Gaulle**
**F-92800 Puteaux (FR)**

(72) Inventeur: **Pribat, Didier**
**THOMSON-CSF SCPI 19, avenue de Messine**
**F-75008 Paris (FR)**

**Dieumegard, Dominique**
**THOMSON-CSF SCPI 19, avenue de Messine**
**F-75008 Paris (FR)**

**Garry, Guy**
**THOMSON-CSF SCPI 19, avenue de Messine**
**F-75008 Paris (FR)**

**Mercandalli, Louis**
**THOMSON-CSF SCPI 19, avenue de Messine**
**F-75008 Paris (FR)**

(74) Mandataire: **Grynwald, Albert et al**
**THOMSON-CSF SCPI**
**F-92045 PARIS LA DEFENSE CEDEX 67 (FR)**

(54) **Dispositif en matériau supraconducteur, et procédé de réalisation.**

(57) Dispositif en matériau supraconducteur dans lequel la couche supraconductrice (1) est encapsulée par au moins un matériau (3) conducteur ionique de l'un des constituants anioniques de la couche supraconductrice (1) ce qui permet de régler la stoechiométrie de la couche supraconductrice (1).

L'invention concerne également un procédé de réglage de la teneur des constituants de la couche supraconductrice (1) par électrolyse.

Applications : Tous dispositifs en couches minces de matériaux supraconducteurs.

FIG_1

EP 0 325 526 A2

Description

## DISPOSITIF EN MATERIAU SUPRACONDUCTEUR ET PROCEDE DE REALISATION

L'invention concerne un matériau supraconducteur et son procédé de réalisation et notamment la réalisation de dispositifs en couches minces de matériaux supraconducteurs à température critique élevée.

Plus précisément l'invention concerne une structure permettant de contrôler avec précision certains constituants du matériau supraconducteur. Par exemple, l'invention permet de contrôler avec précision la teneur en oxygène ou en fluor d'un matériau supraconducteur du type Y-Ba-Cu-O-F.

Depuis la découverte en 1986 de la supraconductivité à 30 K du composé $La_{2-x}Ba_xCu\ O_{4-y}$ par BEDNORZ et MULLER (Z.Phys.B.64. 189.1986), la température critique des oxydes supraconducteurs n'a cessé de croître, résultat d'une mobilisation sans précédent de la communauté scientifique internationale. Ainsi, les nouveaux composés du système Y-Ba-Cu-O présentent actuellement une température critique de l'ordre de 95 K. Il convient de noter qu'à partir du composé étudié par BEDNORZ et MULLER, seule la substitution du lanthane a permis d'augmenter la température critique à 95 K ; la manipulation et le remplacement des autres cations métalliques sont restés jusqu'à ce jour sans effet.

Plus récemment, le remplacement d'une partie de l'oxygène par du fluor a permis d'augmenter encore la température critique dans le système Y-Ba-Cu-O-F, pour porter cette dernière autour de 150 K (voir l'article de S.R. OVSHINSKY et Coll. dans "Physical Review Letters" 15 juin 1987. p. 2579 et voir aussi l'article de MENG WIAN-REN et Coll. dans "Solid State Communications" Vol. 64 N° 3 1987 ; p325).

Cependant le phénomène de perte de résistivité observé semble ne pas être reproductible et pour des raisons non encore expliquées, disparaît après quelques cycles de température entre la température ambiante et celle de l'azote liquide (voir l'article de MENG XIAN-REN et Coll déjà cité).

D'autre part, la composition anionique exacte conduisant à l'apparition de la supraconductivité haute température de l'oxyfluorure est délicate à obtenir. Ce phénomène a déjà été observé dans les oxydes du système Y-Ba-Cu-O comme cela est décrit dans la demande de brevet français N° 87 09463 du 3 juillet 1987. On observe donc une forte dépendance des propriétés supraconductrices avec la teneur en oxygène et en fluor du matériau.

Le procédé selon l'invention permet d'une part d'obtenir des couches minces stables d'oxyfluorure Y-Ba-Cu-O-F supraconducteur et d'autre part de régler de façon précise leur composition en oxygène et en fluor.

Plus généralement l'invention a pour objet un dispositif à matériau supraconducteur dont la structure permet de fixer avec précision la teneur de chacun des éléments anioniques du matériau supraconducteur, ainsi qu'un procédé permettant grâce à une telle structure d'atteindre cette précision de réalisation.

L' invention concerne donc un dispositif en matériau supraconducteur, caractérisé en ce que le matériau supraconducteur ou destiné à l'être est encapsulé par au moins un premier matériau conducteur ionique d'au moins un constituant du matériau supraconducteur et non conducteur ionique de l'oxygène.

L'invention concerne également un procédé de réalisation d'un dispositif en matériau supraconducteur, caractérisé en ce qu'il comporte les étapes suivantes :
- une première étape de réalisation d'une couche en matériau supraconducteur ou destiné à l'être sur un substrat d'un premier matériau ;
- une deuxième étape de réalisation d'une couche d'encapsulation d'un deuxième matériau sur la couche de matériau supraconducteur ou destiné à l'être ;
- une troisième étape de passage d'ions de l'un des constituants anioniques du matériau supraconducteur à travers le premier ou le deuxième matériau ou a travers les deux.

Les différents objets et caractéristiques de l'invention apparaîtront plus clairement dans la description qui va suivre faite à titre d'exemple en se reportant aux figures annexées qui représentent :

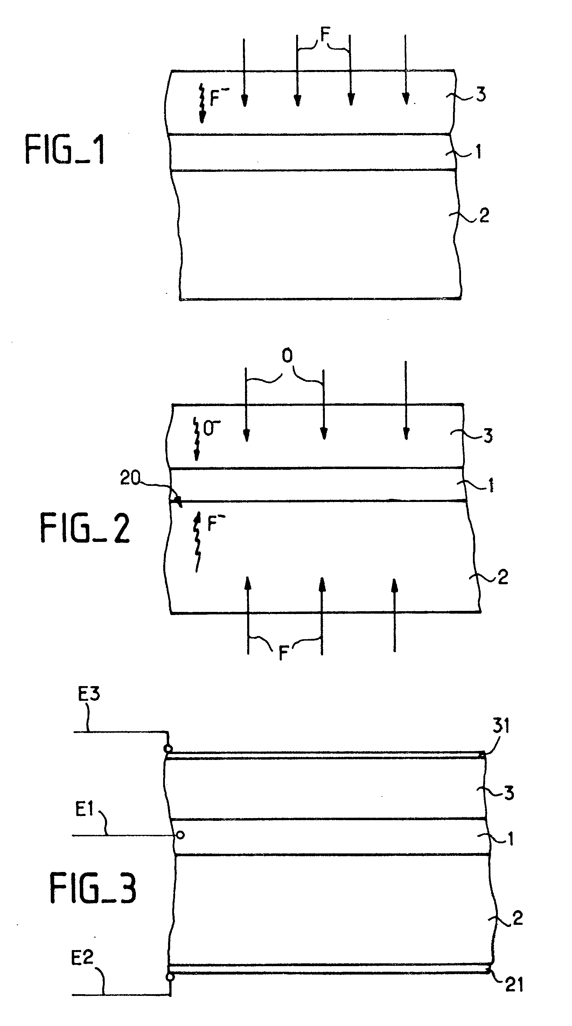

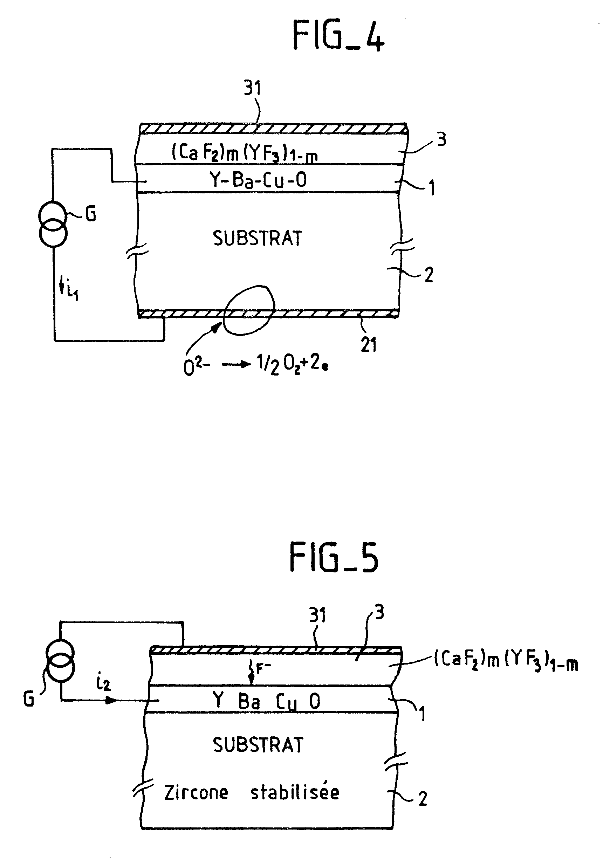

- la figure 1, un exemple de réalisation du dispositif de l'invention dans lequel une couche de matériau supraconducteur ou destiné à l'être est enserrée entre deux autres couches dont l'une au moins est conductrice ionique d'un constituant du matériau supraconducteur ; - la figure 2, une variante de réalisation du dispositif de l'invention ; - la figure 3, un exemple de réalisation du dispositif de l'invention équipée de connexions électriques ; - les figures 4 et 5, des exemples de réalisation d'étapes d'électrolyse faisant partie du procédé de l'invention.

En se reportant à la figure 1, on va tout d'abord décrire un exemple de réalisation général du dispositif selon l'invention.

Le dispositif comporte une couche d'un matériau supraconducteur 1 ou destiné à l'être enserrée entre deux couches 2 et 3.

Selon l'exemple de réalisation simplifié de la figure 1, l'un des matériaux, celui de la couche 2 par exemple, est conducteur ionique de l'un des constituants, anionique notamment, du matériau supraconducteur de la couche 1 à obtenir. Le matériau de l'autre couche 3 n'est pas conducteur ionique Un transport ionique pourra alors se faire à travers la couche 2. Par exemple, pour obtenir un matériau supraconducteur du type Y-Ba-Cu-O-F, la couche 2 pourra être conductrice ionique du fluor, comme cela est représenté en figure 1, pour pouvoir optimiser la teneur en fluor de la couche 1 en vue d'obtenir une température critique déterminée du matériau supraconducteur.

Selon un autre exemple de réalisation, ces matériaux des couches 2 et 3 sont choisis tous deux de façon à permettre la conduction ionique de l'un des constituants anioniques notamment du matériau supraconducteur.

Par contre, ces couches interdisent toute diffusion atomique ou moléculaire des constituants de la couche de matériau supraconducteur 1. La couche 1 se trouve donc encapsulée du point de vue moléculaire et atomique.

Les deux couches 2 et 3 peuvent être réalisées avec le même matériau de façon à permettre la diffusion d'un même type d'ions. Par exemple, pour un matériau supraconducteur du type Y-Ba-Cu-O-F, le matériau des couches 2 et 3 peut être conducteur ionique du fluor, ce qui permet par transport ionique du fluor à travers les couches 2 et 3 d'optimiser la teneur en fluor de la couche 1 en vue de modifier la température critique du matériau supraconducteur.

Cependant, ces exemples de réalisation supposent que seule la teneur d'un constituant ait besoin d'être ajustée, la teneur des autres constituants ayant été déja fixée.

Selon un exemple de réalisation plus complet représenté en figure 2, les couches 2 et 3 sont réalisées à l'aide de matériaux différents permettant chacun une diffusion ionique d'un type d'ions particulier. Par exemple, dans le cas d'un matériau supraconducteur du type Y-Ba-Cu-O-F, l'une des couches, la couche 2 par exemple, est conductrice ionique du fluor, tandis que la couche 3 est conductrice ionique de l'oxygène. Il est ainsi possible par transport d'ions, (par électrolyse en particulier), à travers la couche 3, de régler la teneur en oxygène de la couche supraconductrice 1, puis à travers la couche 2, de régler la teneur en fluor de la couche supraconductrice 1.

Il est bien évident que sans sortir de l'invention, la nature des couches 2 et 3 peuvent être inversée, la couche 2 pouvant alors conduire l'oxygène et la couche 3, le fluor. De même, il est possible que l'une ou l'autre des couches 2 et 3 soit conductrice ionique d'un autre constituant de la couche 1.

Selon l'exemple de réalisation de la figure 2, la couche 2 tient lieu de substrat et possède une face 20 qui porte la couche supraconductrice 1 laquelle est recouverte par la couche 3. Cependant, on peut également prévoir que ce soit la couche 3 qui serve de substrat et possède une face portant la couche 1 recouverte par la couche 2.

La figure 3 représente un exemple de réalisation dans lequel on a prévu sur les faces extérieures des couches conductrices ioniques 2 et 3, des électrodes poreuses, 21 et 31 respectivement. L'électrode 21 laisse passer les molécules ou les atomes du ou des constituants dont est conductrice ionique la couche 2. De même, l'électrode 31 laisse passer les molécules ou les atomes du ou des constituants dont est conductrice ionique la couche 3.

Des connexions électriques E1, E2 et E3 permettent de connecter respectivement la couche supraconductrice 1 et ces électrodes 21 et 31 à un générateur électrique non représenté, et nécessaire à l'électrolyse, permettant le transport ionique à travers les couches 2 et 3.

A titre d'exemple, une couche conductrice de l'oxygène sera réalisée à base de $(ZrO_2)_{1-m} (Y_2O_3)_m$.

Egalement à titre d'exemple, une couche conductrice du fluor sera réalisée à base de :
$(CaF_2$, ou bien de $Ca_{1-x} Y_x F_{2+x})$

Les électrodes poreuses seront réalisées, par exemple à base d'Or ou de platine.

Selon l'invention, la couche supraconductrice 1 est ainsi enserrée entre deux matériaux conducteurs ioniques, soit du fluor, soit de l'oxygène, on peut aisément régler et contrôler la composition en oxygène et en fluor de cette dernière en utilisant les propriétés de transport des électrolytes solides en question.

Les propriétés de transport de l'oxygène sous forme d'ions $O^{2-}$ dans les zircones stabilisées (en couches minces ou matériaux massifs) ainsi que certaines applications exploitant la croissance ou la réduction d'oxyde de semiconducteurs ont été décrites dans les demandes de brevets suivantes :
-N° 82.11215 (Michel CROSET, Michel MERCANDALLI) ayant pour titre : "Procédé de réduction de composé en couche sur un substrat et son application à la fabrication de structure semiconductrice à effet de champ".
-N° 83.04051 (Michel CROSET, Dominique DIEUMEGARD, Didier PRIBAT) ayant pour titre : "Procédé de fabrication d'un dispositif semiconducteur du type comprenant au moins une couche de silicium sur un substrat isolant".

A titre d'exemple, un mécanisme possible d'enrichissement ou de déplétion en oxygène de la couche supraconductrice peut être dérivé à partir de l'article de D. PRIBAT, L.M MERCANDALLI, J. SIEJKA et J. PERRIERE publié dans le Journal Applied Physic, Vol 58, n° 1 du 1er juillet 1985.

En ce qui concerne les propriétés de transport des ions fluor dans les électrolytes solides fluorés, on trouvera dans la littérature un certain nombre de références (voir par exemple L.E. NAGEL et M. O'KEEFFE dans "Fast Ion Transport in Solids" édité par M. VAN GOOL, North Holland, Elsevier 1973 p. 165 ; J.M. REAU et Coll. "Journal of Solid State Chemistry" 17, 1976 p. 123 ; C. LUCAT et Coll. "Annales de chimie" 3, 1978 p. 279 ; K.E.D. WAPENAAR et J. SCHOONMAN. "Journal of Electrochemical Society" 126. 4. 1979 p. 667 ; C. LUCAT et Coll. "Journal of Solid State Chemistry" 29. 1979 p. 373). En particulier, pour le composé $Ca_{1-x} Y_x F_{2+x}$, la conduction ionique pour $(0,06 < x < 0,25)$ semble être associée a la présence de lacunes de fluor dans le sous réseau anionique (voir LUCAT et Coll. déja cités). La conductivité ionique de ce composé peut s'écrire sous la forme
$\sigma = \sigma_o \exp - E_1/kT$ (ou $\sigma_0$ est une constante, $E_i$ l'énergie d'activation, k la constante de Boltzmann et T la température absolue) et à 650°C cette conductivité ionique vaut de l'ordre de $10^{-2}$ $(\Omega$ cm$)^{-1}$ pour x = 0,25. Les solutions solides $CaF_2 + YF_3$ sont de plus très stables thermodynamiquement ce qui rend leur utilisation possible jusqu'à des températures de l'ordre de 1000°C dans des atmosphères oxydantes ou réductrices.

On va maintenant décrire un exemple du procédé de réalisation du dispositif de l'invention décrit précédemment.

Au cours d'une première etape on réalise un dépôt sur un substrat 2 conducteur ionique de l'oxygène (type zircone stabilisée ou cerrine stabilisée) d'une couche mince 1 de matériau Y-Ba-Cu-O. Cette couche est typiquement déposée soit par pulvérisation cathodique (système à cathode unique ou multicible) soit par évaporation sous bombardement électronique (source unique ou système multi-source) soit par une technique du type jet moléculaire ou par croissance en phase vapeur de type CVD ou tout autre procédé approprié.

Au cours d'une deuxième étape, on réalise un dépôt sur la couche mince 1 précédente d'une couche mince 3 conductrice ionique du fluor ($CaF_2$ dopé à l'aide de $YF_3$).

Ce dépôt sera effectué par les techniques connues de l'homme de l'art (pulvérisation cathodique, évaporation sous vide, etc...). L'épaisseur de cette couche mince sera typiquement comprise entre 0,1 et quelques microns.

Au cours d'une troisième étape, on réalise un dépôt sur la couche mince 3 conductrice du fluor d'une première électrode poreuse 31 en or ou en platine.

Au cours d'une quatrième étape, on procède à une réduction de la couche supraconductrice par transport d'ions oxygène au travers du substrat en zircone stabilisée. Cette opération peut s'effectuer thermiquement en plaçant la structure dans une atmosphère réductrice à 800-900°C, (électrode 21 décrite précédemment).

Au cours d'une cinquième étape, on effectue le remplacement de tout ou partie de l'oxygène précédemment enlevé par du fluor en forçant le passage d'un courant d'ions $F^-$ dans l'électrolyte conducteur ionique du fluor (à base de $CaF_2$ par exemple), à partir par exemple d'une source de plasma, la structure étant chauffée entre 150 et 600°C.

Cette cinquième étape est réalisée, comme cela est représenté en figure 5, à l'aide d'un générateur G connecté entre l'électrode 31 et la couche supraconductrice 1.

La source plasma sera réalisée par exemple dans une enceinte à vide pompée à $10^{-2}$ Torrs et alimentée avec du $CF_4$ ou tout autre gaz fluoré susceptible de fournir une source d'ions $F^-$ ; l'excitation électromagnétique sera transmise au moyen d'un couplage inductif ou capacitif.

Au cours d'une sixième étape, le fluor injecté de façon contrôlée dans la couche supraconductrice est éventuellement redistribué par traitement thermique à température comprise entre 500 et 900°C, la couche d'électrolyte solide supérieure bloquant l'exodiffusion de toutes les espèces (anions et cations).

Selon une variante du procédé de l'invention, la troisième étape précédente peut comprendre la réalisation, sur le substrat 2, d'une deuxième électrode poreuse 21 en or ou en platine. La structure obtenue est telle que représentée en figure 3.

Dans ce cas, la quatrième étape précédente est réalisé électrochimiquement, en forçant le passage d'un courant à travers le substrat 1 (en zircone par exemple), au lieu de thermiquement. Cette quatrième étape est alors réalisée selon la figure 4, à l'aide d'un générateur G connecté entre l'électrode 21 réalisée, au cours de la troisième étape (voir paragraphe précédent), et la couche de matériau supraconducteur 1. Au cours de cette étape, l'ensemble de la structure est de préférence porté à une température située entre 200 et 800°C. Les cinquième et sixième étapes du procédé sont ensuite executées comme cela est décrit précédemment.

Les étapes ci-dessus ont été décrites sur la base d'une configuration utilisant un substrat 2 conducteur ionique de l'oxygène et d'une couche 3 conductrice ionique du fluor. On peut bien évidemment adopter une structure où les différentes couches seront déposées sur un substrat conducteur ionique du fluor.

Le procédé précédemment décrit prévoit une réduction de l'oxygène du matériau supraconducteur puis un apport de fluor, cependant on peut également réaliser une oxydo-réduction du matériau supraconducteur suivi d'un apport de fluor ou tout autre opération d'électrolyse.

L'invention consiste donc à réaliser une structure multicouches dans laquelle la couche de matériau supraconducteur d'un type Y-Ba-Cu-O est tout d'abord déposée (par les moyens connus de l'homme de l'art) sur un substrat conducteur ionique de l'oxygène (par exemple, zircone stabilisée à l'oxyde d'yttrium ou de calcium, cerrine stabilisée à l'oxyde d'yttrium, etc...) : on dépose ensuite sur la couche supraconductrice Y-Ba-Cu-O une couche mince 3 d'un matériau conducteur ionique d'un autre constituant tel que du fluor par exemple (la fluorine, la fluorine dopée au fluorure d'yttrium, le difluorure de strontium, etc...) et enfin on dépose sur la couche mince 3 une électrode d'or ou de platine, de façon à pouvoir polariser l'électrolyte solide conducteur du fluor (sous forme d'ions $F^-$). Le procédé de l'invention permettant ainsi, par électrolyse à travers le substrat 2 et la couche 3, de réaliser une oxydo-réduction et un apport d'un autre constituant dans la couche supraconductrice, permettant ainsi d'augmenter la température critique vers 150K.

Il est bien évident que la description qui précède n'a été faite qu'à titre d'exemple non limitatif. D'autres varian tes peuvent être envisagées sans sortir du cadre de l'invention. En particulier on peut envisager de déposer sur le substrat (conducteur ionique de l'oxygène par exemple) une couche de matériau Y-Ba-Cu-O-F et après encapsulation de cette couche à l'aide d'un matériau conducteur ionique du fluor, effectuer des opérations d'oxydo-réduction concernant les deux espèces anioniques, de façon a amener le matériau Y-Ba-Cu-O-F a la composition supraconductrice haute température exacte. Les valeurs numériques n'ont été fournies uniquement que pour illustrer la description. Par ailleurs, l'application de l'invention à une structure permettant une conduction ionique de l'oxygène et du fluor n'a été fournie qu'à titre d'exemple. L'invention est également applicable à titre général à une structure permettant toute autre conduction ionique.

## Revendications

1. Dispositif en matériau supraconducteur caractérisé en ce que le matériau supraconducteur (1), ou destiné à l'être, est encapsulé par au moins un premier matériau (2) conducteur ionique d'au moins un constituant du matériau supraconducteur (1) et non conducteur ionique de l'oxygène.

2. Dispositif en matériau supraconducteur selon la revendication 1, caractérisé en ce que le premier matériau (2) est conducteur ionique du fluor.

3. Dispositif en matériau supraconducteur selon la revendication 1, caractérisé en ce qu'il comporte également un deuxième matériau (3) conducteur ionique de l'oxygène encapsulant en combinaison avec le premier matériau (2) le matériau supraconducteur (1).

4. Dispositif en matériau supraconducteur selon la revendication 3, caractérisé en ce que le deuxième matériau (2) est le substrat du dispositif et qu'il comporte une face (20) sur laquelle est située, sous forme d'une couche, le matériau supraconducteur (1), cette couche de matériau supraconducteur (1) étant recouverte par une couche du premier matériau (3).

5. Dispositif en matériau supraconducteur selon la revendication (3), caractérisé en ce que le premier matériau (3) est le substrat du dispositif et qu'il comporte une face sur laquelle est située, sous forme d'une couche, le matériau supraconducteur (1), cette couche de matériau supraconducteur (1) étant recouverte par une couche du deuxième matériau (2).

6. Dispositif en matériau supraconducteur selon la revendication 2, caractérisé en ce que le premier matériau (2) est à base de fluorine.

7. Dispositif en matériau supraconducteur selon la revendication 3, caractérisé en ce que le deuxième matériau (3) est à base d'oxyde de zirconium stabilisé.

8. Dispositif en matériau supraconducteur selon la revendication 3, caractérisé en ce que chaque couche conductrice ionique (2, 3) comporte une électrode (21, 31) métallique poreuse et des connexions électriques pour la connexion d'une source de courant permettant une électrolyse du dispositif.

9. Dispositif en matériau supraconducteur selon la revendication 8, caractérisé en ce que chaque électrode métallique, associée à un matériau (2, 3) conducteur ionique d'un constituant déterminé du matériau supraconducteur, est perméable aux molécules ou aux atomes de ce constituant déterminé.

10. Procédé de réalisation d'un dispositif en matériau supraconducteur selon l'une quelconque des revendications précédentes, caractérise en ce qu'il comporte les étapes suivantes :
- une première étape de réalisation d'une couche en matériau supraconducteur (1), ou destiné à l'être, sur un substrat d'un premier matériau (2) ;
- une deuxième étape de réalisation d'une couche d'encapsulation d'un deuxième matériau (3) sur la couche de matériau supraconducteur (1) ;
- une troisième étape de passage d'ions de l'un des constituants du matériau supraconducteur (1) à travers le premier ou le deuxième matériau (2, 3) ou à travers les deux.

11. Procédé de réalisation d'un dispositif en matériau supraconducteur selon la revendication 10, caractérisé en ce que le premier matériau (2) ou le deuxième matériau (3) est conducteur ionique de l'un des constituants du matériau supraconducteur (1), tandis que l'autre matériau (2 ou 3) est conducteur ionique de l'oxygène, la troisième étape étant précédée ou suivie d'une étape d'oxydo-réduction à travers la couche conductrice ionique de l'oxygène.

12. Procédé de réalisation d'un dispositif en matériau supraconducteur selon la revendication 10, caractérisé en ce qu'au moins le premier ou le deuxième matériau ou les deux matériaux sont conducteurs ioniques du fluor.

13. Procédé de réalisation d'un dispositif en matériau supraconducteur selon la revendication 11, caractérisé en ce que le premier ou le deuxième matériau est conducteur ionique du fluor tandis que l'autre matériau est conducteur ionique de l'oxygène.

14. Procédé de réalisation d'un dispositif en matériau supraconducteur selon la revendication 12, caractérisé en ce que le matériau conducteur ionique du fluor est à base de fluorine.

15. Procédé de réalisation d'un dispositif en matériau supraconducteur selon la revendication 13, caractérisé en ce que le matériau conducteur ionique de l'oxygène est à base d'oxyde de zirconium stabilisé.

16. Procédé de réalisation d'un dispositif en matériau supraconducteur selon la revendication 10, caractérisé en ce qu'il comporte des étapes de réalisation de connexions sur lesdits premier et deuxième matériaux pour la connexion d'un dispositif d'alimentation de courant électrique et que les étapes de passage d'ions a travers le premier et/ou le deuxième matériau se fait par électrolyse dans une atmosphère contenant des ions à électrolyser.

17. Procédé selon la revendication 10, caractérisé en ce que la troisième étape comporte une phase de réduction de l'oxygène contenu dans la couche supraconductrice (1) à travers le substrat (2) suivie d'une phase d'apport d'un constituant (Fluor) qui se substitue à l'oxygène dans le sous réseau anionique du supraconducteur par passage l'oxygène à travers le deuxième matériau (3).

18. procédé selon la revendication 10, caractérisé en ce que la troisième étape est suivi d'un recuit pour réaliser une redistribution ionique des constituants de la couche supraconductrice (1).

FIG_1

FIG_2

FIG_3

# FIG_4

31

(CaF$_2$)m (YF$_3$)$_{1-m}$    3

Y-Ba-Cu-O    1

G

SUBSTRAT

↑i$_1$    2

21

O$^{2-}$ ⟶ 1/2 O$_2$+2$_e$

# FIG_5

31    3

F$^-$    (CaF$_2$)m (YF$_3$)$_{1-m}$

G    i$_2$    Y Ba Cu O    1

SUBSTRAT

Zircone  stabilisée    2